Europäisches Patentamt

European Patent Office

Office européen des brevets

(19)

(11) Veröffentlichungsnummer: **0 346 508 B1**

(12) # EUROPÄISCHE PATENTSCHRIFT

(45) Veröffentlichungstag der Patentschrift: **03.11.93**

(51) Int. Cl.5: **H03H 17/02**

(21) Anmeldenummer: **88109478.3**

(22) Anmeldetag: **14.06.88**

(54) **Verfahren zum Filtern von digitalen Tonsignalen.**

(43) Veröffentlichungstag der Anmeldung:
**20.12.89 Patentblatt 89/51**

(45) Bekanntmachung des Hinweises auf die
Patenterteilung:
**03.11.93 Patentblatt 93/44**

(84) Benannte Vertragsstaaten:
**AT BE CH DE ES FR GB GR IT LI LU NL SE**

(56) Entgegenhaltungen:

**PROCEEDINGS OF THE IEEE 1986 CUSTOM
INTEGRATED CIRCUITS CONFERENCE,
12.-15. Mai 1986, Seiten 74-77, IEEE, New
York, US; H. AMIR-ALIKHANI et al.: A VLSI
pipeline number theoretic transform processor"**

**ICASSP 86 PROCEEDINGS, 7.-11. April 1986,
Band 1, Seiten 17-20, IEEE, Tokyo, JP; R.
LAGADEC et al.: "Digital data equalizing in
multitrack digital audio recording"**

**ELECTRONICS AND COMMUNICATIONS IN
JAPAN, Band 64, Nr. 12, Dezember 1981, Seiten 27-33, Scripta Publishing CO., Silver
Spring, Maryland, US; T. EDANAMI et al.: "A
new realization of a digital filter using a**

**number theory transform"**

**IEEE TRANS ACOUST, SPEECH AND SIGNAL
PROCESS, Band ASSP-26, Nr. 1, Februar
1978, Seiten 88-93, IEEE, New York, US; H.J.
NUSSBAUMER: "Relative evaluation of various number theoretic transforms for digital
filtering applications"**

**U. Tietze, CH. Schenk; Halbleiter-
Schaltungstechnik, 1983, S. 697 - 718**

(73) Patentinhaber: **WESTDEUTSCHER RUNDFUNK ,
ANSTALT DES ÖFFENTLICHEN RECHTS
Appellhofplatz 1
D-50667 Köln(DE)**

(72) Erfinder: **Drillkens, Richard, Dipl.-Ing.
Zu den Tannen 4
D-4150 Krefeld 1(DE)**

(74) Vertreter: **Konle, Tilmar, Dipl.-Ing.
Benderstrasse 23 a
D-81247 München (DE)**

**Beschreibung**

Die Erfindung bezieht sich auf ein Verfahren gemäß dem Oberbegriff des Patentanspruchs 1. Ein derartiges Verfahren ist aus dem Buch von U. Tietze, Ch. Schenk "Halbleiter-Schaltungstechnik", Springer-Verlag, Berlin - Heidelberg - New York, 1983, Seiten 697 bis 718 bekannt.

Zur Filterung digitaler Signale ist es aus dem vorgenannten Buch von Tietze/Schenk bekannt, die digitalen Signale, welche in Form von Datensegmenten eines beliebig langen Datenstroms vorliegen, einer mathematischen Transformation zu unterziehen. Die resultierenden Transformierten der Datensegmente werden mit der Filterübertragungsfunktion gewichtet. Als Filterübertragungsfunktion dient die Transformierte von Segmenten einer beliebigen endlichen Filterstoßantwort. Zur Gewichtung wird dabei jede Transformierte der Datensegmente mit jeder Transformierten der Stoßantwortsegmente skalar multipliziert. Anschließend erfolgt eine inverse mathematische Transformation der gewichteten Transformierten sowie eine Zusammenfügung der resultierenden Datensegmente zu dem gefilterten, digitalen Signal.

Die zur Transformation üblicherweise angewandte Fast-Fourier-Transformation, abgekürzt "FFT", sieht eine Hintereinanderschaltung einfacher Operationen ("Butterfly") vor, bei denen eine Verdoppelung der Wortlänge erfolgt. In einem Digitalrechner mit endlicher Wortlänge muß das Ergebnis jeder "Butterfly"-Operation auf die einfache Wortlänge zurückgeführt bzw. gewandelt werden, was zu entsprechenden Quantisierungsfehlern bzw. Quantisierungsrauschen führt. Hinzukommt, daß bei der Fourier-Tranformation wegen der Transformationsgleichung

$$X(k) = \sum_{n=0}^{N-1} x(n)\, e^{-j2\pi \cdot n \cdot k/N}$$

mit der Exponentialfunktion $e^{-j\phi t} = \frac{1}{2}(\cos \phi t + \sin \phi t)$
eine genaue Darstellung der Cosinus- und Sinuswerte in einem Digitalrechner ohnehin nur mit Rundungsungenauigkeiten möglich ist, was systembedingt zu Quantisierungsrauschen führt.

Aus dem Tagungsband "Proceedings of the IEEE 1986 Custom Integrated Circuits Conference", 12.-15. Mai 1968, Seiten 74 bis 77 ist es ferner bekannt, die bei der Verwendung einer FFT in einen digitalen Filter mit aus Rundungen und Überlauf resultierenden Probleme durch die Anwendung folgender Transformation zu vermeiden:

$$X(k) = \sum_{n=0}^{N-1} x(n) \cdot \text{alpha}^{n \cdot k}.$$

wobei
x(n)   ein digitales Signal-Datensegment,
(k)    die Transformierte von x(n),
alpha  die Transformationswurzel,
N      die Transformationslänge, und
n, k   ganze Zahlen
darstellen.

Die Transformation kann dabei mittels modularer Arithmetik durchgeführt werden. Die Anwendung einer mit dem Symbol "modulo M" bezeichneten modularen Arithmetik mit einer endlichen Zahlenmenge zwischen 0 und M-1 hat den Vorteil, daß die Ergebnisse immer auf diesen endlichen Zahlenbereich führen, wie nachstehendes Beispiel zeigt:

$\phi = k \cdot (360°) + \beta$ (nicht-modulare Arithmetik)

und

$\phi = \beta$ (modulare Arithmetik).

Damit sind Rundungsoperationen entbehrlich, was Quantisierungsrauschen vermeidet.

Aus der Forderung, daß die modulare Faltung mit einer in "normaler" Arithmetik gerechneten Faltung übereinstimmt, folgen Restriktionen für die Transformationslänge N, den Modul M und die Transformationswurzel alpha.

Bei Verwendung der Transformation für digitale Studio-Tonsignale mit einer 16 Bit-linearen Quantisierung muß der Modul M mindestens 40 bit groß sein, um Überläufe und Übersteuerungen zu vermeiden.

Um dennoch 16 bit-Standard-Hardware benutzen zu können, muß der Modul faktorisiert werden. Bekannt ist die Anwendung des Chinesischen Restsatzes: der Modul M wird in paarweise teilerfremde Faktoren zerlegt, die Transformationen bezüglich der einzelnen Faktoren durchgeführt und so gewonnenen Teilfaltungsergebnisse gemäß dem Chinesischen Restsatz zum Endergebnis zusammengefügt. Diese Lösung bedingt für den letzten Schritt einen Modulo M-Addierer (>40 bit). Der Vorteil der Faktorisierung in Zahlen kleiner 16 bit kann somit nicht durchgängig genutzt werden.

Die Aufgabe der Erfindung besteht demgegenüber dearin, ein Verfahren der eingangs erwähnten Art zur Filterung von digitalen Tonsignalen einzusetzen und dabei Quantisierungsrauschen bei minimalem Rechenaufwand zu vermeiden.

Diese Aufgabe wird **erfindungsgemäß** durch die kennzeichnenden Merkmale des Patentanspruchs 1 gelöst.

Vorteilhafte Ausgestaltungen und Weiterbildungen des erfindungsgemäßen Verfahrens ergeben sich aus dem Unteranspruch.

Erfindungsgemäß wird eine zahlentheoretische Transformation in modularer Arithemtik verwendet, wobei entscheidend ist, daß als Modul M die Potenz einer Primzahl p eingesetzt wird. Die Zahlen werden im Rechner in Polynomform in Abhängigkeit von der Primzahl p dargestellt.:

$$x \bmod p^q = a \cdot p^{q-1} + b \cdot p^{q-2} + ... + r \cdot p + s$$
$$a,b, ...,r,s \ (0,1,...,p-1)$$

Die Arithmetik **modulo $p^q$** läßt sich dann vereinfachend auf eine Arithmetik **modulo p** zurückführen.

Eine vorteilhafte Primzahl für binär orientierte Rechner ist die Fermat-Zahl

$$F_t = 2^b + 1 \text{ mit } \mathbf{b=2^t} \text{ und } \mathbf{t=1,2,3,4.}$$

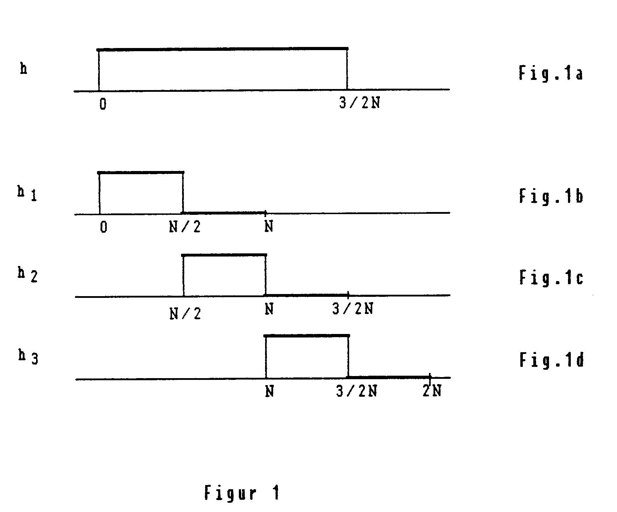

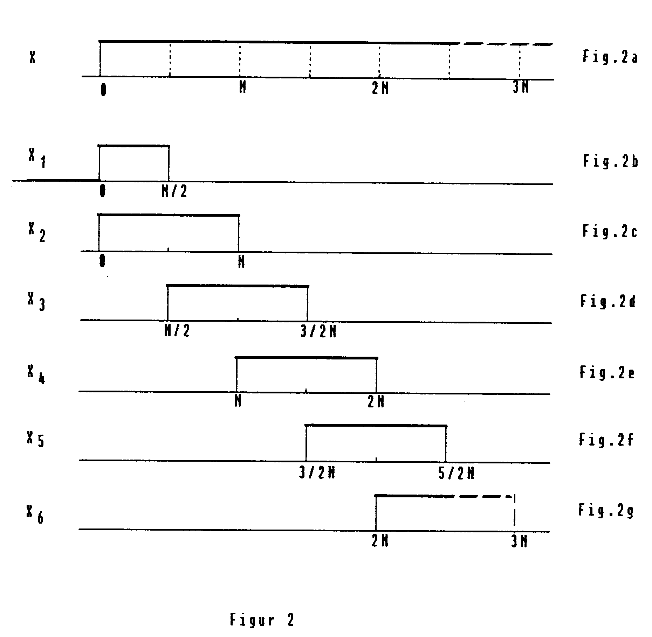

Um eine "unendliche" Datensequenz mit endlichen Filterkoeffizienten zu filtern, sind Methoden bekannt, wie die Datensequenz in endliche Blöcke geteilt, gefiltert und anschließend wieder fehlerfrei aneinandergefügt werden kann. Diese Methoden sind unter dem Oberbegriff "Overlap-Verfahren" zusammengefaßt. Die Fehlerfreiheit an den Stoßstellen der Blöcke wird gewährleistet entweder durch eine Überlappung benachbarter Datenblöcke (s. Fig. 2) oder durch Erweitern des Blocks um "Null"-werte (s. Fig. 1). Die Überlappung bzw. die "Null"-Sequenz muß mit der Länge der Filterstoßantwort übereinstimmen.

Um eine beliebig lange Filterstoßantwort in Echtzeit realisieren zu können, ist vorgesehen, statt des oben genannten Standard-Verfahren (Overlap-Save, Overlapp-Add) ein modifiziertes Overlap-Verfahren zu verwenden, bei dem nicht nur die Datensequenz, sondern auch die Filtersequenz segmentiert wird. Die Vorteile sind, daß die Überlappung der Datensequenzen nicht mehr gleich der Überlappung der Stoßantwort sein muß. Ferner ergeben sich Freiheitsgrade bezüglich des Moduls **M** und der Transformationslänge **N**. Das Endergebnis der kontinuierlichen Faltung läßt sich durch "normale" Addition aus den zeitversetzten Teilergebnissen berechnen.

Aufgrund des modularen Aufbaus des vorgeschlagenen Faltungsalgorithmus ist es möglich, durch Parallelschalten von Rechnersystem mit identischer Software beliebig lange Filter zu realisieren.

Die Erfindung wird nachstehend anhand der Zeichnungen näher erläutert. Es zeigt:

Fign. 1 bis 4     Diagramme von verschiedenen, in der Filteranordnung nach Fig. 5 vorkommenden digitalen Signalen;

Fig. 5     eine Filteranordnung zur Durchführung des erfindungsgemäßen Verfahrens, und

Fig. 6     eine Rechnerschaltung zur Echtzeit-Realisierung der Filterschaltung nach Fig. 5.

Beispielhaft werden als Mustersignale für die Filterstoßantwort sowie die Daten Rechtecke verwendet, da hier die Funktionsweise des Filterverfahrens besonders deutlich wird.

Gemäß Fig. 1 wird die endliche Filterstoßantwort **h** (Fig. 1a) in Segmente $\mathbf{h_i}$ der Länge **N/2** geteilt (Fig. 1b...1d). Der Wert **i** wird beispielshaft zu **3** gewählt. Jedes dieser Segmente $\mathbf{h_i}$ wird mit **N/2** "Null"-Tastwerten zur Transformationslänge **N** ergänzt. Mit Hilfe der vorher beschriebenen zahlentheoretischen Transformation werden die Transformierten **H$_i$** der Segmente **h$_i$** berechnet.

In Fig. 2 ist dargestellt, wie ein "unendlicher" Datenstrom (Fig. 2a) in verarbeitbare Datensegmente **x$_j$** aufgeteilt wird (Fig. 2b...2g). Im Gegensatz zu Fig. 1 haben die Segmente **x$_j$** die Länge **N**, allerdings überlappen sie die benachbarten Segmente um **N/2** Tastwerte. Ebenfalls mit Hilfe der zahlentheoretischen Transformation werden die Transformierten **X$_j$** jedes Segments gebildet.

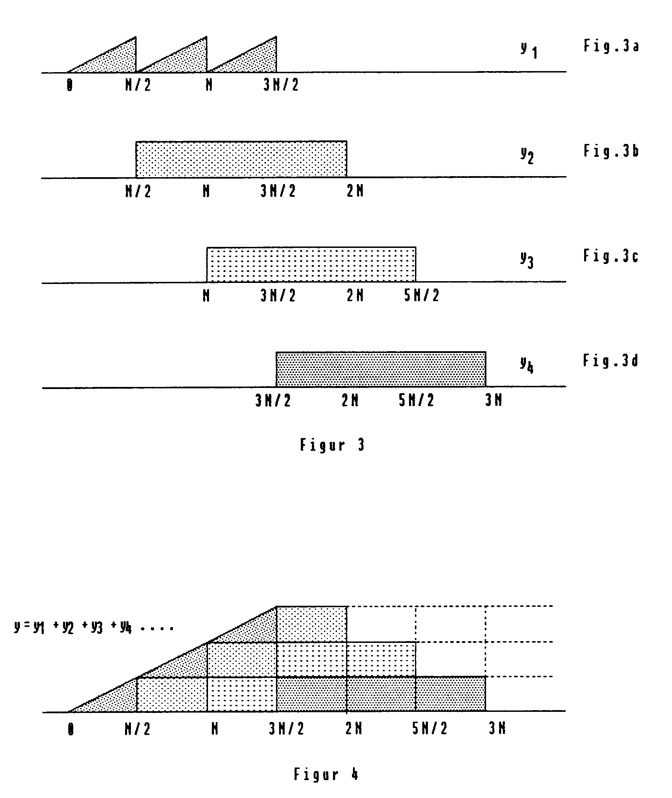

Jede Transformierte **X$_j$** wird mit allen Transformierten **H$_i$** skalar multipliziert und mit Hilfe der inversen zahlentheoretischen Transformation in den Zeitbereich zurücktransformiert. Dabei sind die ersten **N/2** Tastwerte der Filtersegments **Y$_k$** (Fig. 3) Einschwingvorgänge, die bei der Weiterverarbeitung nicht benutzt werden. Die letzten **N/2** Tastwerte bilden aneinandergefügt ein Teilergebnis **y$_1$**,**y$_2$**,**y$_3$**,**y$_4$**..., d.h. den mit allen Stoßantwortsegmenten gefilterten Datenblock **j**. Fig. 3 zeigt die ersten vier Teilergebnisse **y$_1$** bis **y$_4$** für die Signale der Fign. 1 und 2, und zwar: Fig. 3a das gefilterte erste Datensegment entsprechend der Beziehung **x$_1$*h$_1$ + x$_1$*h$_2$ + x$_1$*h$_3$**, Fig. 3b das gefilterte zweite Datensegment, Fig. 3c das gefilterte dritte Datensegment und Fig. 3d das gefilterte vierte Datensegment.

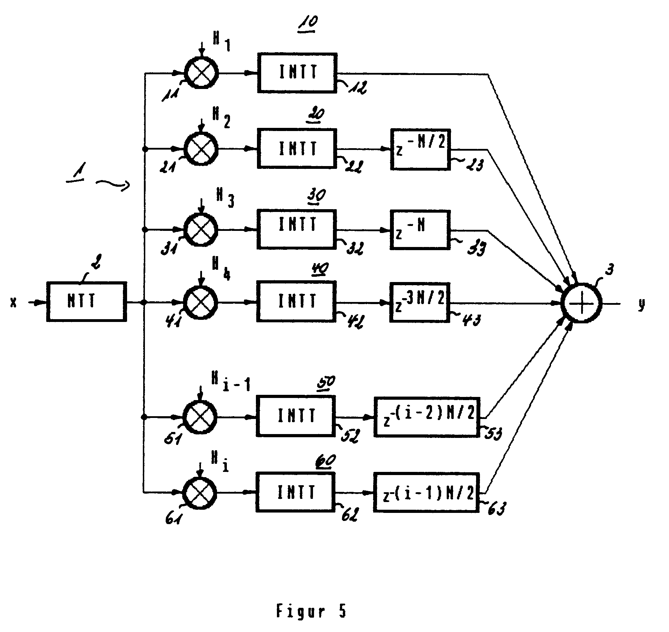

Das Endergebnis wird durch Addition der einzelnen Teilergebnisse (Fig. 3b bis 3d) erzielt, wie in Fig. 4 gezeigt ist.

Eine Filteranordnung 1, die gemäß der Fign. 1 bis 4 arbeitet, ist in Fig. 5 dargestellt.

Die Datensegmente **x** werden einer zahlentheoretischen Transformationsstufe NTT 2 zugeführt, um in den Transformationsbereich übertragen zu werden. Das transformierte Segment **X** am Ausgang der Stufe **2** wird den eingangseitig parallel geschalteten Multiplizierstufen **11...61** parallel zugeführt, wo es mit den **i** Transformierten **H$_i$** der Filterstoßantwort skalar multipliziert wird. Dabei kann **i** eine beliebige ganze Zahl sein, d.h. daß die Filterstoßantwort beliebig lang sein kann, da in Abhängigkeit von der Transformationslänge **N** die Filterstoßantwort in mehr oder weniger Segmente zerlegt wird. Es müssen somit nur entsprechend mehr Zweige **10, 20,... 60** vorgesehen werden.

Das Multiplikationsergebnis wird in jedem Zweig **10 ... 60** mittels einer inversen zahlentheoretischen Transformationsstufe INTT **12...62** in den Zeitbereich zurücktransformiert, anschließend in Abhängigkeit von der zeitlichen Position des Filtersegments **h$_i$** (s. Fig. 1) mittels einer Verzögerungsstufe **23...63** zeitverzögert (mit Ausnahme des ersten Zweiges **10**) und in einer Akkumulationsstufe **3** mit den anderen Zweigsignalen aufaddiert. Das resultierende Ausgangssignal der Akkumulationsstufe **3** stellt das gefilterte Datensignal **y** gemäß Fig. 4 dar.

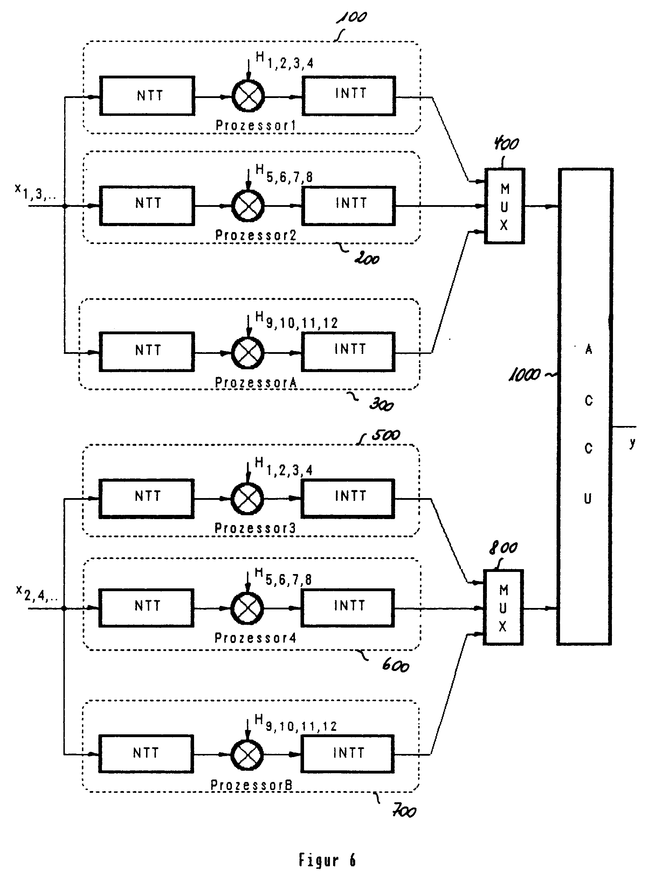

Fig. 6 zeigt eine für Echtzeitverarbeitung ausgelegte Rechnerschaltung für die Filteranordnung 1 gemäß Fig. 5.

Wegen der 50%-Überlappung der Datensegmente **x$_j$** (s. Fig. 2b...2g) wird die Verarbeitung parallel in den Zweigen **100...300** und **500...700** durchgeführt.

Die Berechnung in den einzelnen Zweigen **100...700** erfolgt mit identischer Soft- und Hardware. Beispielhaft wird angenommen, daß ein durch einen Prozessor gebildeter Zweig **100, 200, ... 700** jeweils vier Segmente **h$_i$** einer Filterstoßantwort verarbeiten kann. Eine Erweiterung auf längere Filterstoßantworten erfolgt durch Parallelschalten von Prozessoren in den Verarbeitungszweigen **100...700**.

Die in Fig. 5 angedeuteten Zeitverzögerungsstufen **23...63** werden durch die Multiplexer **400** und **800** simuliert, von denen der Multiplexer **400** den Zweigen **100, 200, 300** und der Multiplexer **800** den Zweigen **500, 600, 700** zugeordnet ist. In der den Multiplexern **400, 800** nachgeordneten Akkumulationsstufe **1000** werden die Verarbeitungszweige **100...700** zusammengefaßt und deren Signale aufaddiert, so daß am Ausgang der Stufe **1000** das Datensignal **y** zur weiteren Verarbeitung verfügbar ist.

Als Transformationsmodul **M** ist die Potenz einer Primzahl zu verwenden, um eine ausreichende Dynamik der Filterung zu erzielen. Um eine Realisierung der oben erwähnten Prozessoren bit binär arbeitenden Rechenbausteinen zu ermöglichen, wird als Primzahl eine sogenannte Fermatzahl **F$_t$** gemäß

$$F_t = 2^b + 1$$

mit **b=2$^t$** und **t=1,2,3** oder **4** vorgesehen.

Hierdurch lassen sich ferner Transformationswurzeln **alpha** angeben, welche als 2-er-Potenzen darstellbar sind, so daß sich die in der Transformation notwendige skalare Multiplikation mit einfachen Bit-Shifts (z.B. mittels sogenannter Barrel-Shifter) realisieren lassen.

## Patentansprüche

1.  Verfahren zum Filtern von digitalen Tonsignalen, bei dem

- die in Form von Datensegmenten ($x_j$) eines beliebig langen Datenstroms vorliegenden digitalen Tonsignale einer mathematischen Transformation unterzogen werden;
- die Transformierten($X_j$) der Datensegmente ($x_j$) mit einer Filterübertragungsfunktion gewichtet werden;
- die gewichteten Transformierten ($X_j \cdot H_i$) einer inversen mathematischen Transformation unterzogen werden, und
- die daraus resultierenden, gefilterten Datensegmente ($y_k$) unter Bildung des gefilterten digitalen Tonsignals (**y**) zusammengefügt werden,

wobei

(a) als Filterübertragungsfunktion die Transformierte ($H_i$) von Segmenten ($h_i$) einer beliebigen endlichen Filterstoßantwort (**h**) vorgesehen ist,

und

(b) jede Transformierte ($X_i$) der Datensegmente ($x_i$) mit jeder Transformierten ($H_i$) der Stoßantwortsegmente ($h_i$) skalar multipliziert wird,

**dadurch gekennzeichnet,** daß als mathematische Transformation eine zahlentheoretische Transformation gemäß der Systemgleichung

$$X(k) = \left[ \sum_{n=0}^{N-1} x(n) \cdot alpha^{n \cdot k} \right] \; modulo \; M$$

vorgesehen ist, wobei

| | |
|---|---|
| **x(n)** | ein digitales Tonsignal-Datensegment |
| **X(k)** | die Transformierte von **x(n)** |
| **alpha** | die Transformationswurzel |
| **M** | der Modul |
| **N** | die Transformationslänge |
| **n, k** | ganze Zahlen |

bedeuten, und

daß der Modul (**M**) für die zahlentheoretische Transformation (**NTT**) eine Potenz einer Primzahl ist, wobei die Exponenten 0 und 1 ausgeschlossen sind.

2. Verfahren nach Anspruch 1, **dadurch gekennzeichnet,** daß als primzahl eine fermat-Zahl ($F_t$) gemäß der Gleichung

$$F_t = 2^b + 1$$

mit $b = 2^t$ und **t = 1, 2, 3 oder 4**
vorgesehen ist.

**Claims**

1. Method for the filtering of digital audio signals in which
   - the digital audio signals present in the form of data segments ($x_j$) of a data current of any length are subjected to a mathematical transformation;
   - the transformed ($X_j$) of the data segments ($x_j$) are weighted with a filter transfer function;
   - the weighted transformed ($X_j \cdot H_i$) are subjected to an inverse mathematical transformation and
   - the filtered data segments ($y_k$) resulting therefrom are combined forming the filtered digital audio signal (y),

   whereby

   (a) as filter transfer function the transformed ($H_i$) of segments ($h_i$) of any finite filter impact reply (h) is provided,

   and

   (b) each transformed ($X_i$) of the data segments ($x_i$) is scalarmultiplied with each transformed ($H_i$) of the impact reply segments ($h_i$),

characterised in that as mathematical transformation a numerical theoretical transformation according to the system equation

$$X(k) = \left[ \sum_{n=0}^{N-1} x(n) \cdot alpha^{\,n \cdot k} \right] modulo\ M$$

is provided whereby

| | |
|---|---|
| x(n) | signifies a digital audio signal data segment |
| X(k) | the transformed from x(n) |
| alpha | the transformation root |
| M | the modulus |
| N | the transformation length |
| n, k | whole numbers |

and that the modulus (M) for the numerical theoretical transformation (NTT) is a power of a prime number whereby the exponents 0 and 1 are excluded.

2. Method according to claim 1, characterised in that as prime number a fermat-number ($F_t$) according to the equation

$$F_t = 2^b + 1$$

with $b = 2^t$ and $t = 1, 2, 3$ or $4$
is provided.

**Revendications**

1. Procédé pour filtrer des signaux audio numériques, selon lequel
   - les signaux audio numériques, se présentant sous forme de segments de données ($x_j$) d'un flux de données de longueur quelconque, sont soumis à une transformation mathématique;
   - les transformées ($X_j$) des segments de données ($x_j$) sont pondérées d'une fonction de transfert de filtre;
   - les transformées pondérées ($X_j \cdot H_i$) sont soumises à une transformation mathématique inverse et
   - les segments de données filtrés ($y_k$) qui en résultent sont réunis, avec formation du signal audio numérique filtré (y),

   étant entendu que

   (a) la transformée ($H_i$) de segments ($h_i$) d'une réponse impulsionnelle de filtre (h) finie quelconque est prévue comme fonction de transfert de filtre et
   (b) chaque transformée ($X_i$) des segments de données ($x_i$) est soumise à une multiplication scalaire par chaque transformée ($H_i$) des segments de réponse impulsionnelle ($h_i$),

   caractérisé en ce que, comme transformation mathématique, on prévoit une transformation de la théorie des nombres, selon l'équation de système

$$X(k) = \left[ \sum_{n=0}^{N-1} x(n) \cdot alpha^{\,n \cdot k} \right] modulo\ M$$

où:

| | |
|---|---|
| x(n) | = un segment de données du signal audio numérique |
| X(k) | = la transformée de x(n) |
| alpha | = la racine de la transformation |

6

M   = le module
N   = la longueur de la transformation
n, k  = des nombres entiers
et que le module (M) pour la transformation (NTT) de la théorie des nombres est une puissance d'un nombre premier, avec exclusion des exposants 0 et 1.

2. Procédé selon la revendication 1, caractérisé en ce que, comme nombre premier, on prévoit un nombre de Fermat ($F_t$) selon l'équation

$$F_t = 2^b + 1$$

avec $b = 2_t$ et $t = 1, 2, 3$ ou $4$.

h

Fig.1a

0                                          3/2N

h$_1$

Fig.1b

0        N/2        N

h$_2$

Fig.1c

N/2        N        3/2N

h$_3$

Fig.1d

N        3/2N        2N

Figur 1

X
Fig.2a

0    N    2N    3N

X$_1$
Fig.2b

0    N/2

X$_2$
Fig.2c

0    N

X$_3$
Fig.2d

N/2    3/2N

X$_4$
Fig.2e

N    2N

X$_5$
Fig.2f

3/2N    5/2N

X$_6$
Fig.2g

2N    3N

Figur 2

Figur 3

Figur 4

Figur 5

Figur 6